# DEMANDE DE BREVET EUROPEEN

(11) **EP 4 617 230 A1**
(43) Date de publication de la demande: **17.09.2025**
(21) Numéro de dépôt: 24163664.6
(22) Date de dépôt: 14.03.2024
(51) Int. Cl.: B81C 99/00, G04B 17/06, G04B 13/02, G04B 15/14, G04D 3/00

(54) **PROCÉDÉ DE FABRICATION D'UNE PIÈCE HORLOGÈRE À PARTIR D'UNE PLAQUETTE DE BASE**

(71) Demandeur: Richemont International S.A., 1752 Villars-sur-Glâne (CH)
(72) Inventeur: CHABART, Mickaël, 2014 Fleurier (CH)
(74) Mandataire: Novagraaf International SA

(57) **Abrégé**

L'invention se rapporte à un procédé de fabrication d'au moins une pièce horlogère (90) à partir d'une plaquette de base (10), comprenant les étapes consistant à :
- se munir de la plaquette de base (10), formée en un matériau de base homogène d'une épaisseur au moins sensiblement égale à une épaisseur maximale de la pièce horlogère (90) et présentant une face supérieure et une face inférieure,
- former par oxydation thermique une couche d'oxyde sur la face supérieure et sur la face inférieure de la plaquette de base (10), la couche d'oxyde formée limitant les contraintes et/ou déformations au sein de la plaquette,
- former la pièce horlogère (90) par une technique de photolithographie - gravure de la face supérieure oxydée,
- libérer la pièce horlogère (90).

## Description

### Domaine technique de l'invention

La présente invention concerne de manière générale la fabrication de pièces horlogères. En particulier, la présente invention se rapporte à la fabrication de pièces horlogères à partir d'une plaquette, par exemple une plaquette de silicium qui peut subir une gravure ionique réactive profonde.

### État de la technique

Il est connu du document EP3495894 de fabriquer des pièces horlogères à partir d'une plaquette relativement mince en silicium, qui peut être oxydée pour qu'une face de la plaquette soit recouverte d'une couche d'oxyde de silicium initiale avant la formation des pièces horlogères. Les contraintes induites par la formation d'une telle couche d'oxyde peuvent générer des déformations sur la plaquette, dégradant sa planéité. De plus, la formation d'une couche d'oxyde initiale peut nécessiter des opérations particulières de manipulation conduisant à un procédé complexe et long, comprenant donc des risques d'endommagement de la plaquette en silicium.

### Exposé de l'invention

Un but de la présente invention est de répondre aux inconvénients de l'art antérieur mentionnés ci-dessus et en particulier, tout d'abord, de proposer un procédé de fabrication d'au moins une pièce horlogère à partir d'une plaquette de base qui permette de limiter les contraintes appliquées sur la plaquette et les risques de déformations associées, et/ou qui permette de simplifier le procédé global de fabrication pour obtenir une plaquette de silicium oxydée.

Pour cela un premier aspect de l'invention concerne un procédé de fabrication d'au moins une pièce horlogère à partir d'une plaquette de base, comprenant les étapes consistant à :
- se munir de la plaquette de base, formée en un matériau de base homogène d'une épaisseur au moins sensiblement égale à une épaisseur maximale de la pièce horlogère et présentant une face supérieure et une face inférieure,
- former par oxydation thermique une couche d'oxyde sur la face supérieure et sur la face inférieure de la plaquette de base formée en matériau de base homogène, la couche d'oxyde formée limitant les contraintes et/ou déformations au sein de la plaquette de base,
- former, à partir de la face supérieure oxydée, la pièce horlogère par une technique de photolithographie - gravure de la face supérieure oxydée et du matériau de base homogène,
- libérer la pièce horlogère de la couche d'oxyde de la face supérieure et de la couche d'oxyde de la face inférieure. Selon la mise en oeuvre ci-dessus, les deux faces (supérieure et inférieure) la plaquette de base sont oxydées, si bien que les contraintes et/ou déformations sont équilibrées de part et d'autre. En d'autres termes, la formation par oxydation thermique d'une couche d'oxyde sur la face supérieure et sur la face inférieure permet de, ou a pour fonction de, limiter les contraintes et/ou déformations au sein de la plaquette de base.

Dans la présente demande, la plaquette de base présente une face supérieure et une face inférieure, c'est-à-dire deux surfaces opposées séparées l'une de l'autre par l'épaisseur de la plaquette de base. Si la plaquette est de forme extérieure circulaire, la face supérieure et la face inférieure sont deux disques (autrement dit, des surface circulaires). Typiquement, la plaquette de base est découpée dans un lingot, et tant qu'aucun traitement n'est apporté à la plaquette de base, la face supérieure et la face inférieure sont identiques et ne peuvent pas être distinguées l'une de l'autre. Autrement dit, la dénomination face supérieure et face inférieure est arbitraire tant qu'on ne peut pas distinguer ces deux faces.

Le procédé de fabrication peut être défini par les caractéristiques suivantes, prises individuellement ou en combinaison.

Selon un mode de réalisation, l'épaisseur de la plaquette de base est sensiblement égale à une épaisseur maximale de la pièce horlogère.

Selon un mode de réalisation, la formation de la couche d'oxyde sur la face supérieure est effectuée de manière au moins partiellement simultanée avec la formation de la couche d'oxyde sur la face inférieure. Effectuer en même temps l'oxydation sur la face supérieure et sur la face inférieure permet de limiter les contraintes et/ou déformations au sein de la plaquette. En effet, les deux faces sont exposées aux mêmes moments aux mêmes conditions de température et d'humidité, ce qui ne provoque aucun différentiel entre les deux faces. Cela permet aussi de réduire le nombre d'opérations, puisque les deux faces sont oxydées en même temps et aucune opération de retournement n'est requise.

Selon un mode de réalisation, la formation de la couche d'oxyde sur la face supérieure et sur la face inférieure est effectuée en tenant la plaquette de base sensiblement verticale dans une enceinte d'oxydation. Ainsi, la plaquette de base ne repose sur aucun support et la face supérieure ainsi que la face inférieure sont accessibles et exposées à l'atmosphère oxydante.

Selon un mode de réalisation, la formation de la couche d'oxyde sur la face supérieure et sur la face inférieure est effectuée en suspendant la plaquette de base dans l'enceinte d'oxydation. La manipulation et la mise en place sur le montage dans le four d'oxydation sont simplifiées. On peut aussi noter que suspendre la plaquette de base impose peu de contraintes au matériau. On peut aussi noter que les risques de casse sont réduits en suspendant la plaquette de base, surtout si son épaisseur est faible (de 0.1 mm à 0.5 mm par exemple).

Selon un mode de réalisation, le procédé de fabrication comprend une étape consistant à suspendre plusieurs plaquettes de base sur un même support dans une enceinte d'oxydation. Selon un mode de réalisation, le procédé de fabrication comprend une étape consistant à positionner plusieurs plaquettes de base parallèlement les unes aux autres. On peut prévoir d'utiliser un berceau avec par exemple des fentes de positionnement, pour garantir que les plaquettes de base seront bien parallèles entre elles, et à tout le moins n'entreront pas en contact au cours de l'oxydation.

Selon un mode de réalisation, le procédé de fabrication comprend une étape préliminaire consistant à former dans la plaquette de base une forme traversante pour suspendre la plaquette de base, telle qu'un trou. Un tel trou est aisé à fabriquer et cela permet de suspendre aisément la plaquette de base dans le four ou dans l'enceinte d'oxydation. On peut aussi noter qu'un tel trou, typiquement excentré du centre de la plaquette de base, procure un index ou un point de référence, ce qui permet d'orienter la plaquette de base et/ou de retrouver une orientation aisément, par exemple lors d'étapes ultérieures de gravure ou de texturation.

Selon un mode de réalisation, la formation de la couche d'oxyde sur la face supérieure est effectuée de manière séquentielle avec la formation de la couche d'oxyde sur la face inférieure. On peut prévoir d'effectuer deux opérations successives d'oxydation de la plaquette sur un support, la plaquette de base restant libre, non collée, et non liée au support.

Selon un mode de réalisation, une étape de retournement de la plaquette de base sur un support est effectuée entre la formation de la couche d'oxyde sur la face supérieure et la formation de la couche d'oxyde sur la face inférieure. Ainsi, la plaquette de base peut reposer sur un support pendant l'oxydation d'une de ses faces, mais peut ensuite être retournée par rapport à ce support.

Selon un mode de réalisation, l'étape de retournement comprend une étape initiale de soulèvement de la plaquette de base depuis son support, effectuée par application d'une pression pneumatique depuis le support ou par un ascenseur traversant le support. Un décollement assisté ou automatique permet de limiter les risques de casse, surtout pour décoller la plaquette de base de son support. On peut noter que cette étape peut être exécutée hors de l'enceinte d'oxydation thermique. On peut poser le support et la plaquette de base sur un outillage dédié au retournement, qui assite au décollement pour limiter les risques de rayures ou d'endommagement liés à une opération purement manuelle.

Selon un mode de réalisation, le procédé de fabrication comprend une étape de bridage de la plaquette de base sur un support avant la formation de la couche d'oxyde sur la face supérieure et/ou avant la formation de la couche d'oxyde sur la face inférieure. Un tel bridage permet de limiter les déplacements intempestifs et/ou les rayures.

Selon un mode de réalisation, l'étape de bridage comprend l'application d'un effort de plaquage de la plaquette de base sur son support par :
- une masse telle qu'un anneau reposant sur la plaquette de base, et/ou
- un vide ou une aspiration généré(e) depuis le support,
- une force électrostatique appliquée sur la plaquette. Par exemple, un anneau posé sur la plaquette de base laisse toute la surface centrale accessible et est simple à manipuler.

Selon un mode de réalisation, l'application de l'effort de plaquage par une masse est effectuée sur des portions à plaquer prédéterminées et/ou dédiées de la plaquette de base, et distinctes de zones dédiées à la fabrication de ladite au moins une pièce horlogère, dans lequel les portions à plaquer sont agencées :
- en périphérie de la plaquette de base, et/ou
- dans une zone de la plaquette de base, agencée entre deux zones dédiées à la fabrication de ladite au moins une pièce horlogère. L'anneau (ou la masse) posé sur la plaquette de base empêche localement l'oxydation aux points de contact, mais on choisit de poser l'anneau sur une zone de la plaquette qui ne sera pas utilisée pour fabriquer des pièces d'horlogerie.

Selon un mode de réalisation, l'étape de formation de la pièce horlogère par photolithographie-gravure comprend au moins :
- une étape consistant à placer ou déposer la plaquette de base sur un support de photolithographie-gravure,
- une étape consistant à brider au moins temporairement la plaquette de base sur un support de photolithographie-gravure, avec :
   - une force de bridage exercée par une masse sur la plaquette de base, et/ou
   - la dépose de colle, de préférence photosensible, en périphérie de la plaquette de base, et/ou
   - une solidarisation à froid avec un métal tel que de l'or, et/ou
   - un ruban adhésif, de préférence photosensible, et/ou
   - un vide ou une aspiration généré(e) au travers du support de photolithographie-gravure.

Selon un mode de réalisation, l'étape consistant à brider au moins temporairement la plaquette de base sur le support de photolithographie-gravure avec la force de bridage exercée par une masse sur la plaquette de base est effectuée en exerçant la force de bridage sur les portions à plaquer prédéterminées et/ou dédiées de la plaquette de base, et distinctes des zones dédiées à la fabrication de ladite au moins une pièce horlogère.

Selon un mode de réalisation, l'étape de libération de la pièce horlogère de la couche d'oxyde de la face supérieure et de la couche d'oxyde de la face inférieure comprend au moins une étape consistant à poser la plaquette de base sur un support de libération, et dans lequel le support de libération comprend des protrusions et/ou des zones évidées pour permettre la libre circulation d'un agent de libération au moins en regard d'une face inférieure de ladite au moins une pièce horlogère. Ainsi, le support de libération est texturé ou ajouré pour être en contact avec la plaquette de base uniquement aux endroits où il n'y a pas de pièce horlogère gravée.

Selon un mode de réalisation, le support de libération est agencé pour contacter la plaquette de base sur des portions à supporter prédéterminées et/ou dédiées de la plaquette de base, et distinctes de zones dédiées à la fabrication de ladite au moins une pièce horlogère, et les portions à supporter sont de préférence identiques ou en regard avec les portions à plaquer utilisées lors de l'étape d'application de l'effort de plaquage par une masse et effectuée sur les portions à plaquer prédéterminées et/ou dédiées de la plaquette de base, et distinctes de zones dédiées à la fabrication. On utilise les mêmes zones lors du bridage et lors de la libération, ce qui permet de tenir fermement la plaquette de base.

Selon un mode de réalisation, le matériau de base de la plaquette de base est du silicium, et dans lequel la couche d'oxyde est de l'oxyde de silicium.

En d'autres termes, l'invention concerne un procédé de fabrication d'une pièce horlogère à partir d'une plaquette de base, comprenant les étapes consistant à :
- se munir de la plaquette de base, formée en un matériau homogène d'une épaisseur sensiblement égale à une épaisseur maximale de la pièce horlogère et présentant une première face, telle qu'une face supérieure et une deuxième face, telle qu'une face inférieure,
- former une couche d'oxyde sur la première face et sur la deuxième face de la plaquette de base formée en matériau homogène,
- former, à partir de la première face oxydée, la pièce horlogère par une technique de photolithographie - gravure du matériau homogène,
- libérer la pièce horlogère de la couche d'oxyde de la première face et de la couche d'oxyde de la deuxième face.

### Description des figures

D'autres caractéristiques et avantages de la présente invention apparaîtront plus clairement à la lecture de la description détaillée qui suit de mode(s) de réalisation de l'invention donné(s) à titre d'exemple(s) nullement limitatif(s) et illustré(s) par les dessins annexés, dans lesquels :
[fig. 1] représente des plaquettes de base placées dans une enceinte en vue d'effectuer une étape d'oxydation ;
[fig. 2] représente les plaquettes de base de la figure 1, au cours de l'étape d'oxydation ;
[fig. 3] représente une plaquette de base sur un support en vue d'effectuer une étape d'oxydation ;
[fig. 4] représente la plaquette de base de la figure 3 au cours de l'étape d'oxydation ;
[fig. 5] représente la plaquette de base de la figure 4 après une opération de retournement en vue d'effectuer une autre étape d'oxydation ;
[fig. 6] représente la plaquette de base de la figure 5 au cours de l'autre étape d'oxydation ;
[fig. 7] représente un outillage pouvant être utilisé pour les étapes d'oxydation des figures 4 ou 6 ;
[fig. 8] représente la plaquette de base de la figure 6 complètement oxydée ;
[fig. 9] représente une étape de recouvrement de la plaquette de base de la figure 8 par de la résine ;
[fig. 10] représente une étape de masquage de la résine déposée à la figure 9 ;
[fig. 11] représente une étape d'irradiation de la résine déposée à la figure 9 ;
[fig. 12] représente une étape de texturation de la résine irradiée à la figure 10 ;
[fig. 13] représente une étape de gravure d'une couche d'oxyde de la plaquette de base au travers de la résine texturée de la figure 12 ;
[fig. 14] représente une étape de gravure ionique réactive profonde de la plaquette de base au travers de la couche d'oxyde et de la résine texturée de la figure 12 ;
[fig. 15] représente une étape de désoxydation de la plaquette de base ;
[fig. 16] représente la plaquette de base désoxydée ;
[fig. 17] représente un outillage pouvant être utilisé pour effectuer une ou plusieurs des étapes des figures 12 à 15 ;
[fig. 18] représente un outillage pouvant être utilisé pour effectuer une ou plusieurs des étapes des figures 12 ou 13.

### Description détaillée de mode(s) de réalisation

Dans tout ce qui suit, les orientations sont définies en fonction des orientations des figures. En particulier, les termes comme « supérieur », « inférieur », « gauche », « droit », « dessus », « dessous », « vers l'avant » et « vers l'arrière » s'entendent généralement par rapport au sens de représentation des figures discutées. Les figures sont schématiques et peuvent présenter des proportions et/ou des aspects différents de la réalité même au sein d'une même figure, mais illustrent à tout le moins le déroulement et/ou les étapes des procédés décrits.

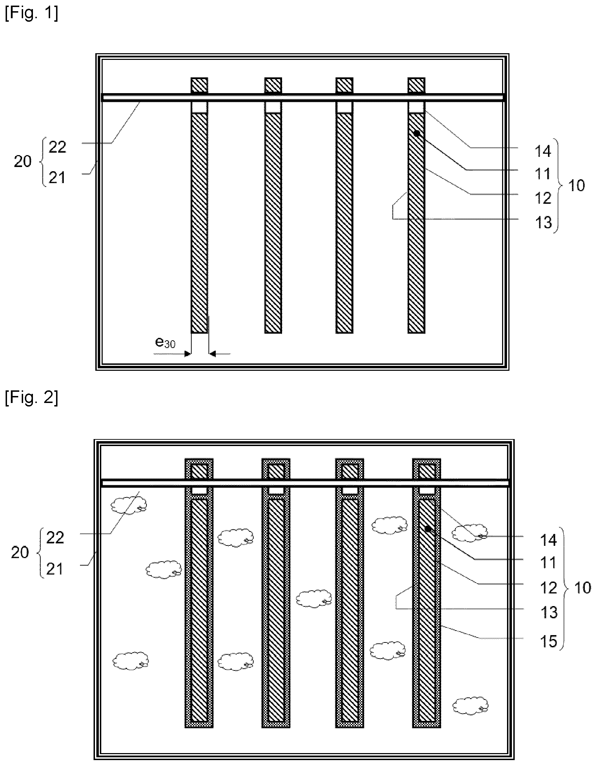

La figure 1 représente des plaquettes de base 10 placées dans une enceinte de traitement 20 en vue d'effectuer une étape d'oxydation thermique. Chaque plaquette de base 10 comprend une couche simple 11, une face supérieure 12 (ou une première face 12), une face inférieure 13 (ou une deuxième face 13) et un trou traversant 14.

L'enceinte de traitement 20 comprend schématiquement une cloison 21 et une tige support 22 formée ici par une barre, sur lequel les plaquettes de base 10 sont suspendues.

Typiquement, les plaquettes de base 10 peuvent être réalisées en silicium monocristallin avec une orientation cristalline quelconque, en silicium polycristallin, ou en silicium amorphe, et elles peuvent être dopées type N ou type P. L'utilisation d'un silicium fortement dopé peut être avantageuse pour la fabrication des résonateurs car, par exemple, on constate une déformation moindre de la matière dopée lors de l'oxydation thermique sous certaines conditions.

Aussi, les plaquettes de base 10 peuvent présenter une épaisseur de 150 µm - 500 µm, et de préférence de 200 µm - 300 µm. Dans un exemple, la couche simple 11 a une épaisseur e₃₀ de 250 µm. On comprend que les plaquettes de base 10 sont fragiles et les suspendre dans l'enceinte de traitement 20 chacune par leur trou 14 sur la tige support 22 permet de limiter les risques de casse. On peut alternativement ou en addition prévoir un berceau qui peut les maintenir à l'écart les unes des autres. La tige support 22 peut également être crantée pour prédéfinir les positions des plaquettes de base 10 suspendues.

La figure 2 représente les plaquettes de base 10 de la figure 1, au cours de l'étape d'oxydation thermique, pour former une couche d'oxyde 15. La couche d'oxyde 15 peut par exemple avoir une épaisseur comprise entre 0.4 et 6 µm, et elle est formée par oxydation thermique comme dans un four ou enceinte comme illustré dans la figure 2. L'oxydation thermique dans le four a lieu de préférence à une température comprise entre 800°C et 1200°C et dans une atmosphère oxydante comprenant par exemple la vapeur d'eau ou du gaz de dioxygène (O2). L'épaisseur de la couche d'oxyde formée dépend de manière connue de la durée de l'étape d'oxydation. Puisque la couche d'oxyde 15 est formée par oxydation thermique, on remarque que l'oxyde se forme généralement en même temps sur la face inférieure 13 de la couche simple 11 et sur la face supérieure 12. Ainsi, au cours d'une même opération, la face supérieure et la face inférieure sont oxydées, si bien que les contraintes thermiques et mécaniques appliquées à la plaquette de base 10 sont faibles voire nulles.

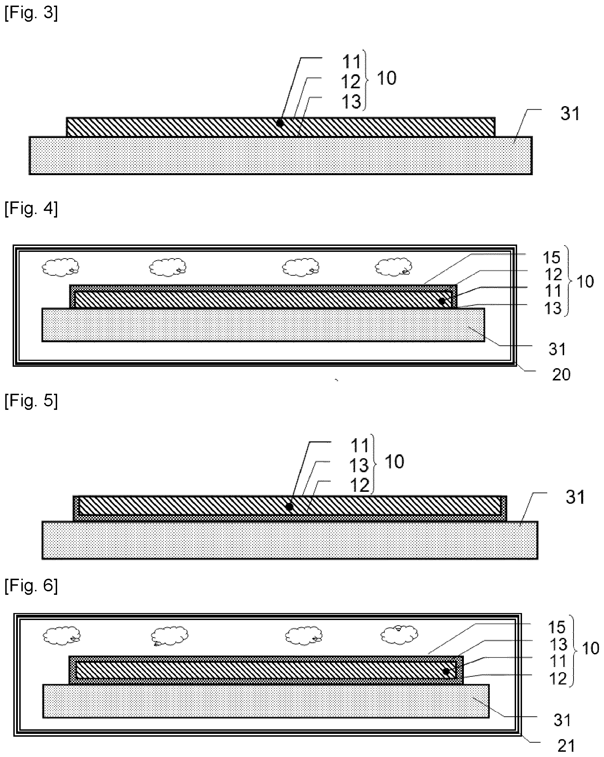

La figure 3 représente une plaquette de base 10 sur un support 31 en vue d'effectuer une étape d'oxydation thermique. Alternativement à l'étape d'oxydation de la figure 2, on peut prévoir d'oxyder les plaquettes de base 10 à plat sur un support 31. Un tel support 31 peut être par exemple en métal, en céramique, en verre ou en quartz, et de préférence le support 31 est plus épais et/ou plus rigide que la couche simple 11 afin qu'il soit plus facile à manipuler. Par ailleurs, pour au moins certaines des étapes, la couche simple 11 peut également être liée temporairement à un tel support par des moyens adhésifs (par exemple de la colle ou un ruban adhésif appliqué à la périphérie de la couche) ou un système d'aspiration sous vide, ou par application d'un poids, ou par une force électrostatique.

Sur la figure 3, la face inférieure 13 de la plaquette de base 10 est posée sur le support 31.

La figure 4 représente la plaquette de base de la figure 3 au cours de l'étape d'oxydation thermique, placée dans l'enceinte de traitement 20 pour former une couche d'oxyde 15 notamment sur la face supérieure 12. La couche d'oxyde 15 peut par exemple avoir une épaisseur comprise entre 0.4 et 6 µm.

La figure 5 représente la plaquette de base 10 de la figure 4 après une opération de retournement sur le support 31 en vue d'effectuer une autre étape d'oxydation. Sur la figure 5, la face supérieure 12 de la plaquette de base 10 est posée sur le support 31. Pour effectuer le retournement, on peut prévoir un soufflage au travers de trous ménagés dans le support 31, ou un système d'ascenseur (une ou plusieurs tige(s) coulissante(s) dans le support 31). Ainsi, le décollement et le retournement sont facilités, sans endommager la plaquette de base 10.

La figure 6 représente la plaquette de base 10 de la figure 5 au cours de l'autre étape d'oxydation thermique, placée dans l'enceinte de traitement 20 pour former une couche d'oxyde 15 notamment sur la face inférieure 13. Ici encore, la couche d'oxyde 15 peut par exemple avoir une épaisseur comprise entre 0.4 et 6 µm. A l'issue de l'étape de la figure 6, toute la plaquette de base 10 est oxydée, en particulier, la face supérieure 12 et la face inférieure 13 sont recouvertes d'une couche d'oxyde de silicium 15.

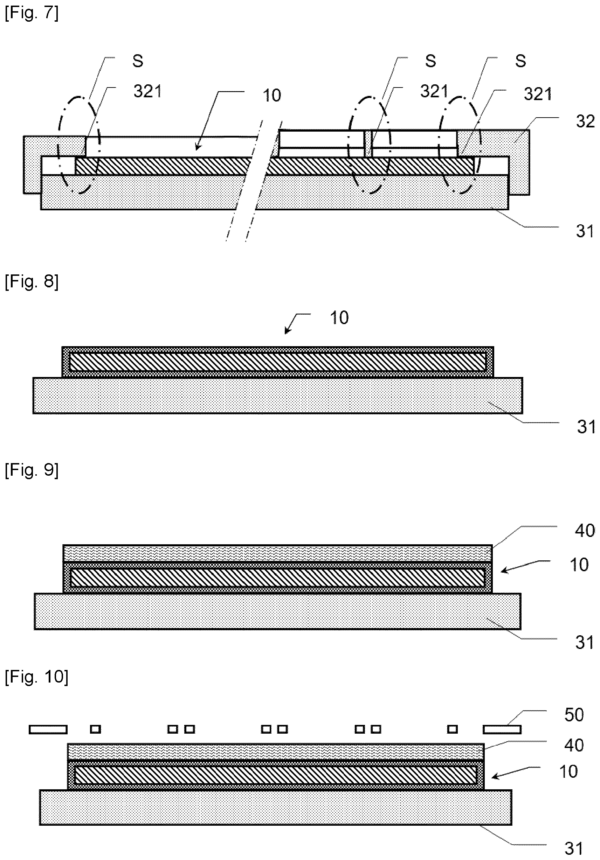

De manière générale, la formation de la couche d'oxyde 15 sur la face supérieure 12 avant le dépôt d'une couche de résine (voir la figure 9) permet de déposer une couche de résine relativement fine et uniforme avec une bonne homogénéité de surface et ainsi d'optimiser la gravure subséquente de motifs fins et profonds dans la couche simple 11.

La figure 7 représente un outillage 32 pouvant être utilisé pour les étapes d'oxydation des figures 4 ou 6. En effet, il peut être avantageux de brider la plaquette de base 10 sur le support 31 pour éviter tout déplacement relatif qui risque d'affecter la qualité des pièces. A cet effet, l'outillage de bridage 32 est prévu pour coiffer la plaquette de base 10 et se centrer sur le support 31, pour appliquer un effort de bridage par son propre poids.

La partie de gauche de la figure 7 montre une première variante de réalisation, où l'outil de bridage 32 n'appuie que sur la périphérie de la plaquette de base 10. La partie de droite de la figure 7 montre une deuxième variante de réalisation, où l'outil de bridage 32 appuie sur la périphérie de la plaquette de base 10 et sur des zones centrales de la plaquette de base 10.

D'une manière générale, l'outillage de bridage 32 comprend des zones de contact 321 qui sont prévues pour appuyer sur la plaquette de base 10 à des endroits où aucune pièce horlogère ne sera formée : en périphérie, ou entre des zones à graver pour former des pièces horlogères. L'effort de plaquage est donc appliqué sur des portions à plaquer S visibles sur la figure 7 et qui ne sont pas destinées à former des pièces horlogères.

La figure 8 représente la plaquette de base 10 de la figure 6 complètement oxydée, reposant sur un support 31 et prête à subir des étapes de lithographie et de gravure. Par « lithographie », on entend l'ensemble des opérations permettant de transférer une image ou un motif sur ou au-dessus de la plaquette de base 10 vers cette dernière.

La figure 9 représente une étape de recouvrement de la face supérieure 12 de la plaquette de base 10 de la figure 8 par de la résine 40, qui est typiquement une résine photosensible de type positif ou négatif. Cette couche de résine peut avoir une épaisseur comprise entre 0.5 - 12 µm, à titre purement illustratif.

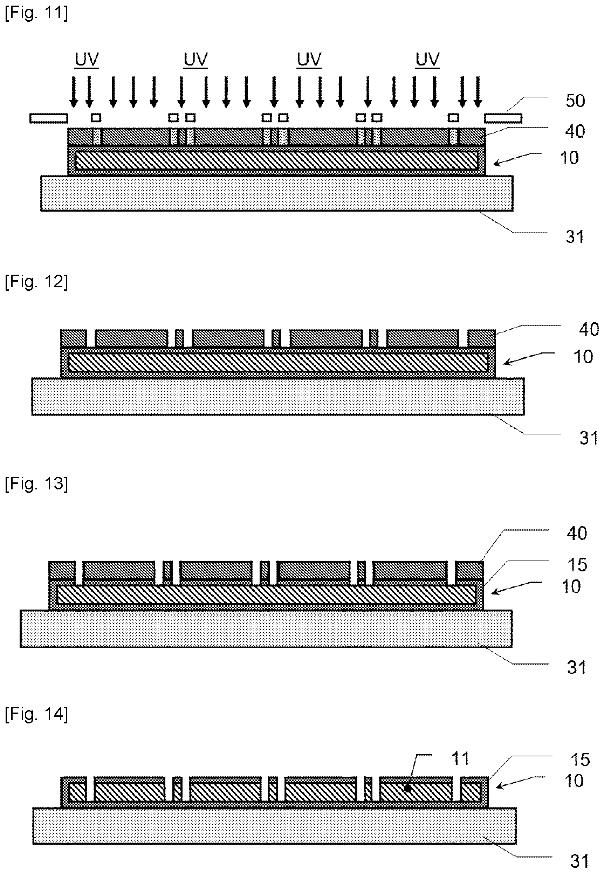

Par la suite, dans la figure 10, un photo-masque 50 est positionné au dessus de la résine 40. La figure 11 représente une étape d'irradiation de la résine 40 déposée à la figure 9, au travers du photo-masque positionné au dessus de la résine à la figure 10, avec une source de lumière ultraviolette. Un système de stepper et réticule peut également être utilisé pour l'étape de photolithographie. Dans l'exemple illustré, la couche de résine 40 comprend une résine photosensible de type positif dont les parties de la résine 40 qui sont exposées à la lumière deviennent solubles dans un révélateur et les parties non exposées restent insolubles. Selon d'autres modes de réalisation, la résine peut être structurée par un faisceau laser ou d'électrons.

La figure 12 représente la plaquette de base 10 après une étape de texturation de la résine 40 irradiée à la figure 11. La couche de résine 40 est ouverte après avoir été développée par un révélateur, notamment un solvant qui élimine les parties exposées de la résine 40 par voie chimique. Ensuite, à la figure 13, les parties de la couche oxyde 15 qui se trouvaient en dessous des parties exposées de la résine sont aussi retirées de la face supérieure 12 de la plaquette de base 10, par exemple en employant une gravure plasma sélective avec les gaz CH₄/O₂. L'utilisation d'une technique de gravure directionnelle est généralement privilégiée lors de cette étape car elle est plus précise, mais alternativement une gravure à base de vapeur d'acide fluorhydrique (HF) peut aussi être utilisée.

Après élimination de la couche de résine structurée 40, la figure 14 représente une étape de gravure ionique réactive profonde de la plaquette de base 10 au travers de la couche d'oxyde 15 structurée sur la face supérieure 12 de la plaquette . Des motifs séparés par des tranchées sont gravés dans la couche simple 11 au travers de la couche 15 structurée pour former les pièces horlogères dans une couche simple 11 structurée. De préférence dans ce mode de réalisation, les motifs gravés et donc les tranchées s'étendent sur toute l'épaisseur de la couche simple 11 tel qu'illustré, et à cette fin la couche d'oxyde 15 de la face inférieure 13 peut agir comme une couche d'arrêt lors de la gravure. Dans ce cas, l'épaisseur maximale des pièces horlogères correspond à l'épaisseur de la couche simple 11 structurée. Dans d'autres exemples, l'épaisseur de la couche simple 11 peut être plus importante que l'épaisseur maximale des pièces horlogères.

La gravure à l'étape de la figure 14 peut notamment être effectuée par une technique de gravure ionique réactive profonde (également connue sous l'acronyme DRIE pour « Deep Reactive Ion Etching » en anglais). La gravure DRIE permet d'usiner des trous et des tranchées profondes dans la couche simple 11 avec un rapport largeur/hauteur important, ce qui est bien adapté pour des composants micromécaniques comme des pièces horlogères. Alternativement, la structuration de la couche simple 11 peut être réalisée par d'autres technologies de gravure telles qu'une opération de gravure humide/chimique anisotrope, par exemple en utilisant un bain d'hydroxyde de potassium (KOH) ou d'hydroxyde de tétraméthylammonium (TMAH). Une structuration par gravure humide/chimique peut notamment être plus rapide qu'une gravure ionique réactive profonde, mais la résolution dimensionnelle des structures gravées est généralement moins bonne.

Il est également possible pour la partie restante de la couche de résine 40 d'être toujours présente lors de l'étape de gravure (DRIE ou autre) de la couche simple 11. Cette partie restante de la couche de résine peut être retirée après la gravure, et dans ce cas la couche simple 11 est gravée au travers des deux couches de résine et d'oxyde structurées. A titre d'exemple, une résine positive peut être retirée par des solvants de type acétone ou diméthylsulfoxyde (DMSO) ou avec un plasma O₂, soit avant soit après l'étape de gravure. Pour une résine négative comme le SU-8, un plasma CF₄/O₂ peut être employé pour son retrait.

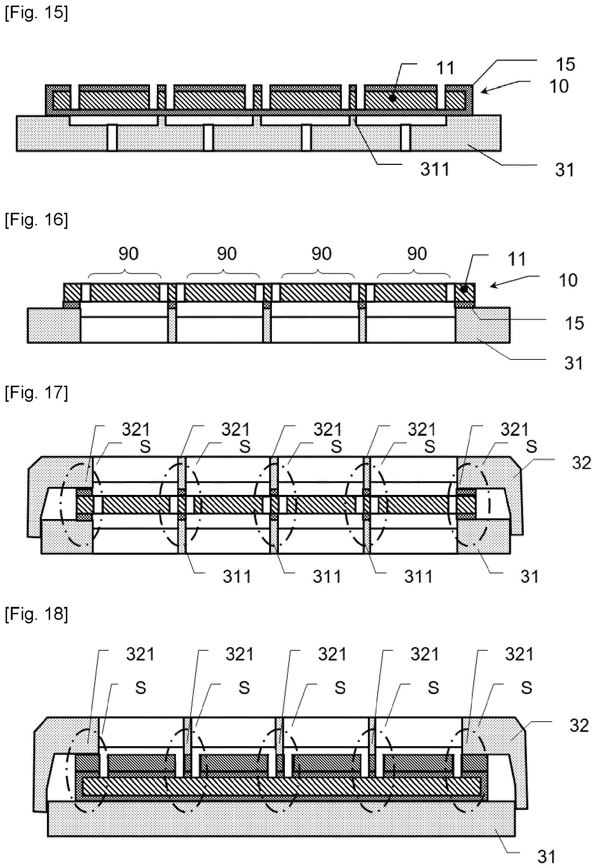

La figure 15 représente une étape de désoxydation de la plaquette de base 10, au cours de laquelle on effectue une désoxydation pour éliminer la couche d'oxyde 15 autour des pièces horlogères. A cet effet, on peut utiliser un support 31 évidé en dessous des pièces horlogères, le support 31 comprenant des protrusions 311 qui contactent la plaquette de base 10 au niveau de zones qui ne sont pas destinées à former des pièces horlogères. Autrement dit, le support 31 ne contacte la plaquette de base que dans des zones périphériques, ou dans des zones situées entre les futures pièces horlogères. Cette étape de désoxydation est de préférence réalisée par une gravure par voie humide ou en phase vapeur à base d'acide fluorhydrique (HF). Comme le montre la figure 15, le support 31 peut comprendre des trous pour faciliter l'accès à la face de la plaquette de base 10 en regard du support 31.

La figure 16 représente la plaquette de base 10 désoxydée, avec les pièces horlogères 90 libérées de la couche d'oxyde 15. On peut noter que la figure 16 montre qu'il reste une partie de la couche d'oxyde 15 entre la plaquette de base 10 et le support 31, mais cet oxyde de silicium peut tout à fait aussi avoir disparu lors de la désoxydation opérée figure 15.

Après les étapes décrites ci-dessus, les pièces horlogères 90 formées dans la couche simple 11 structurée sont libres et ne sont supportés structurellement que par des ponts de liaison dans cette couche afin que les pièces horlogères restent attachées aux parties subsistantes de cette couche simple 11. De tels ponts ne sont pas représentés figures 16 et s'étendent typiquement sur toute l'épaisseur des pièces horlogères. Il est alors possible par la suite d'effectuer des étapes de fabrication subséquentes sur la quasi-totalité de la surface externe des pièces horlogères 90 formées dans la couche simple 11 structurée.

Les étapes subséquentes peuvent par exemple comprendre un ou plusieurs jeux d'étapes d'oxydation et de désoxydation pour lisser les surfaces des pièces horlogères et/ou pour ajuster les dimensions des pièces. Un tel ajustement peut notamment être employé pour corriger la raideur quand les pièces horlogères sont des spiraux ou des résonateurs. Une étape d'oxydation sans désoxydation (ou sans désoxydation complète) est également possible pour former une couche externe d'oxyde de silicium permanente sur les pièces horlogères. Dans le cadre d'un spiral ou d'un autre type de résonateur horloger, une telle couche d'oxyde permanente compense les variations du module d'Young de l'âme en silicium de la pièce horlogère en fonction de la température. Par ailleurs, la formation d'une telle couche externe d'oxyde de silicium sur les pièces horlogères de n'importe quel type peut également servir à renforcer ces pièces horlogères mécaniquement. D'autres types de matériaux peuvent également être formés sur les pièces horlogères, par exemple par un dépôt type ALD.

La figure 17 représente un outillage pouvant être utilisé pour effectuer une ou plusieurs des étapes ci-dessus, comme celles des figures 12 à 15. Pour limiter les risques de mouvements relatifs entre la plaquette de base 10 et le support 31, il peut être avantageux de prévoir un outillage de bridage 32 qui applique son propre poids sur la plaquette de base. L'outillage de bridage 32 peut se centrer sur le support 31.

Dans l'exemple de la figure 17, le support 31 tout comme l'outillage de bridage 32 sont ajourés ou évidés pour laisser un accès direct aux pièces horlogères à former ou formées dans la plaquette de base 10. En effet, le support 31 comprend des protrusions 311 tout comme l'outillage de bridage 32 comprend des protrusions 321 qui définissent des zones de contact S avec la plaquette de base 10 où aucune pièce horlogère n'est à former. Ainsi, la plaquette de base 10 est fermement tenue, les pièces horlogères à former ou formées sont accessibles aux traitements et l'ensemble représenté figure 17 est aisé à manipuler.

La figure 18 représente une variante de l'outillage de la figure 17, pouvant être utilisée pour effectuer une ou plusieurs des étapes des figures 12 ou 13. Dans la variante de la figure 18, le support 31 n'est pas ajouré ni évidé, seul l'outillage de bridage 32 est ajouré / évidé avec des protrusions 321 qui définissent des zones de contact S avec la plaquette de base 10 où aucune pièce horlogère n'est à former.

### Application industrielle

Un procédé de fabrication selon la présente invention est susceptible d'application industrielle.

On comprendra que diverses modifications et/ou améliorations évidentes pour l'homme du métier peuvent être apportées aux différents modes de réalisation de l'invention décrits dans la présente description sans sortir du cadre de l'invention.

En particulier, l'outillage de bridage 32 peut être un simple anneau à poser en périphérie de la plaquette de base pour la maintenir sur le support 31. Par ailleurs, on peut prévoir de tirer partie du trou 14 de la plaquette de base 10 qui peut former une empreinte de positionnement, avec un téton du support 31 qui peut recevoir le trou 14 pour indexer ou positionner la plaquette de base 10.

## Revendications

1. Procédé de fabrication d'au moins une pièce horlogère (90) à partir d'une plaquette de base (10), comprenant les étapes consistant à :
- se munir de la plaquette de base (10), formée en un matériau de base homogène d'une épaisseur au moins sensiblement égale à une épaisseur maximale de la pièce horlogère (90) et présentant une face supérieure et une face inférieure,
- former par oxydation thermique une couche d'oxyde sur la face supérieure et sur la face inférieure de la plaquette de base (10) formée en matériau de base homogène, la couche d'oxyde formée limitant les contraintes et/ou déformations au sein de la plaquette,
- former, à partir de la face supérieure oxydée, la pièce horlogère (90) par une technique de photolithographie - gravure de la face supérieure oxydée et du matériau de base homogène,
- libérer la pièce horlogère (90) de la couche d'oxyde de la face supérieure et de la couche d'oxyde de la face inférieure.

2. Procédé de fabrication selon la revendication 1, dans lequel l'épaisseur de la plaquette de base (10) est sensiblement égale à une épaisseur maximale de la pièce horlogère (90).

3. Procédé de fabrication selon la revendication 1 ou 2, dans lequel la formation de la couche d'oxyde sur la face supérieure est effectuée de manière simultanée avec la formation de la couche d'oxyde sur la face inférieure.

4. Procédé de fabrication selon la revendication 3, dans lequel la formation de la couche d'oxyde sur la face supérieure et sur la face inférieure est effectuée en tenant la plaquette de base (10) sensiblement verticale dans une enceinte d'oxydation.

5. Procédé de fabrication selon l'une des revendications 1 à 4, dans lequel la formation de la couche d'oxyde sur la face supérieure et sur la face inférieure est effectuée en suspendant la plaquette de base (10) dans l'enceinte d'oxydation.

6. Procédé de fabrication selon l'une des revendications 3 à 5, comprenant une étape préliminaire consistant à former dans la plaquette de base (10) une forme traversante pour suspendre la plaquette de base (10), telle qu'un trou.

7. Procédé de fabrication selon la revendication 1 ou 2, dans lequel la formation de la couche d'oxyde par oxydation thermique sur la face supérieure est effectuée de manière séquentielle avec la formation de la couche d'oxyde sur la face inférieure.

8. Procédé de fabrication selon la revendication 7, dans lequel une étape de retournement de la plaquette de base (10) sur un support est effectuée entre la formation de la couche d'oxyde sur la face supérieure et la formation de la couche d'oxyde sur la face inférieure.

9. Procédé de fabrication selon la revendication 8, dans lequel l'étape de retournement comprend une étape initiale de soulèvement de la plaquette de base (10) depuis son support, effectuée par application d'une pression pneumatique depuis le support ou par un ascenseur traversant le support.

10. Procédé de fabrication selon l'une des revendications 7 à 9, comprenant une étape de bridage de la plaquette de base (10) sur un support avant la formation de la couche d'oxyde sur la face supérieure et/ou avant la formation de la couche d'oxyde sur la face inférieure.

11. Procédé de fabrication selon la revendication 10, dans lequel l'étape de bridage comprend l'application d'un effort de plaquage de la plaquette de base (10) sur son support par :
- une masse telle qu'un anneau reposant sur la plaquette de base (10), et/ou
- un vide ou une aspiration généré(e) depuis le support, et/ou
- une force électrostatique appliquée sur la plaquette.

12. Procédé de fabrication selon la revendication 11, dans lequel l'application de l'effort de plaquage par une masse est effectuée sur des portions à plaquer prédéterminées et/ou dédiées de la plaquette de base (10), et distinctes de zones dédiées à la fabrication de ladite au moins une pièce horlogère (90), dans lequel les portions à plaquer sont agencées :
- en périphérie de la plaquette de base (10), et/ou
- dans une zone de la plaquette de base (10), agencée entre deux zones dédiées à la fabrication de ladite au moins une pièce horlogère (90).

13. Procédé de fabrication selon l'une des revendications 1 à 12, dans lequel l'étape de formation de la pièce horlogère (90) par photolithographie-gravure comprend au moins :
- une étape consistant à placer la plaquette de base (10) sur un support de photolithographie-gravure,
- une étape consistant à brider au moins temporairement la plaquette de base (10) sur le support de photolithographie-gravure, avec :
• une force de bridage exercée par une masse sur la plaquette de base (10), et/ou
• la dépose d'une colle, de préférence photosensible, en périphérie de la plaquette de base (10), et/ou
• une solidarisation à froid avec un métal tel que de l'or, et/ou
• un ruban adhésif, de préférence photosensible, et/ou
• un vide ou une aspiration généré(e) au travers du support de photolithographie-gravure.

14. Procédé de fabrication selon la revendication 13 dans sa dépendance à la revendication 11, dans lequel l'étape consistant à brider au moins temporairement la plaquette de base (10) sur le support de photolithographie-gravure avec la force de bridage exercée par une masse sur la plaquette de base (10) est effectuée en exerçant la force de bridage sur les portions à plaquer prédéterminées et/ou dédiées de la plaquette de base (10), et distinctes des zones dédiées à la fabrication de ladite au moins une pièce horlogère (90).

15. Procédé de fabrication selon l'une des revendications 1 à 14, dans lequel l'étape de libération de la pièce horlogère (90) de la couche d'oxyde de la face supérieure et de la couche d'oxyde de la face inférieure comprend au moins une étape consistant à poser la plaquette de base (10) sur un support de libération, et dans lequel le support de libération comprend des protrusions et/ou des zones évidées pour permettre la libre circulation d'un agent de libération au moins en regard d'une face inférieure de ladite au moins une pièce horlogère (90).

16. Procédé de fabrication selon la revendication 15, dans lequel le support de libération est agencé pour contacter la plaquette de base (10) sur des portions à supporter prédéterminées et/ou dédiées de la plaquette de base (10), et distinctes de zones dédiées à la fabrication de ladite au moins une pièce horlogère (90).

17. Procédé de fabrication selon l'une des revendications 1 à 15, dans lequel le matériau de base de la plaquette de base (10) est du silicium, et dans lequel la couche d'oxyde est de l'oxyde de silicium.
